(19) Europäisches Patentamt
European Patent Office
Office européen des brevets

(11) **EP 3 016 818 B1**

(12) **FASCICULE DE BREVET EUROPEEN**

(45) Date de publication et mention de la délivrance du brevet:
**05.04.2017 Bulletin 2017/14**

(21) Numéro de dépôt: **14735614.1**

(22) Date de dépôt: **12.06.2014**

(51) Int Cl.:
*B60L 3/00* (2006.01)     *G01R 27/18* (2006.01)
*G01R 31/00* (2006.01)

(86) Numéro de dépôt international:
**PCT/FR2014/051438**

(87) Numéro de publication internationale:
**WO 2015/001218 (08.01.2015 Gazette 2015/01)**

(54) **PROCÉDÉ DE DETERMINATION DE LA PRÉSENCE D'UN RÉSEAU D'ALIMENTATION DE TYPE IT ALIMENTANT UN CHARGEUR DE BATTERIE AUTOMOBILE ET CHARGEUR CORRESPONDANT**

VERFAHREN ZUR BESTIMMUNG DER ANWESENHEIT EINES IT-VERSORGUNGSNETZES ZUR VERSORGUNG EINER KRAFTFAHRZEUG-BATTERIELADEVORRICHTUNG UND ENTSPRECHENDE LADEVORRICHTUNG

METHOD OF DETERMINING THE PRESENCE OF A SUPPLY NETWORK OF IT TYPE FOR SUPPLYING AN AUTOMOBILE BATTERY CHARGER AND CORRESPONDING CHARGER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **02.07.2013 FR 1356431**

(43) Date de publication de la demande:
**11.05.2016 Bulletin 2016/19**

(73) Titulaire: **Renault S.A.S.**
**92100 Boulogne-Billancourt (FR)**

(72) Inventeur: **MERIENNE, Ludovic**
**F-91190 Gif Sur Yvette (FR)**

(56) Documents cités:
**EP-A2- 0 959 361     EP-A2- 2 505 415**

**Description**

L'invention a pour domaine technique les chargeurs de batteries de véhicules automobiles, et plus particulièrement la sécurité électrique de tels chargeurs.

Lors de la charge de la batterie d'un véhicule électrique ou hybride, des courants intenses transitent du réseau d'alimentation électrique vers la batterie du véhicule. Pour pouvoir charger correctement la batterie du véhicule, ces courants sont hachés de manière à respecter les contraintes du réseau. Le hachage des courants entraîne l'apparition de courants de fuite qui doivent être évacués par la prise de terre du réseau. Cette terre est reliée au châssis du véhicule et offre donc un chemin à tous les courants parasites.

Pour assurer une charge en toute sécurité, il faut que la liaison à la terre soit de bonne qualité, c'est-à-dire que la résistance équivalente du chemin de terre soit faible devant la résistance qu'offrirait un être humain en contact avec les extrémités du chemin de terre.

Lorsque la liaison à la terre est absente, il peut apparaître un phénomène dit de « courant de toucher ». Dans de telles conditions, le corps de l'être humain qui viendrait à toucher le châssis du véhicule fermerait le circuit entre le chargeur et la terre. C'est donc par lui que passeraient tous les courants de toucher, courants potentiellement dangereux.

La situation est également dangereuse lorsque la liaison à la terre est de mauvaise qualité, c'est-à-dire de résistance équivalente à un corps humain. Dans de telles conditions, le corps de l'être humain qui viendrait à toucher le châssis du véhicule, créerait un circuit parallèle à celui de la liaison à la terre. Les courants de fuite pourraient alors transiter par deux chemins parallèles de même résistance. Dans cette situation, une partie au moins des courants de fuite passeraient par l'être humain pour revenir à la terre, ce qui constitue une situation très dangereuse. Pour éviter qu'un courant de toucher dangereux puisse apparaître et pour pouvoir procéder à la charge de la batterie en sécurité, il faut que la valeur de la résistance de liaison à la terre soit inférieure à un certain seuil.

Des techniques pour mesurer la résistance de terre existent et reposent notamment sur l'injection de courant dans la prise de terre par l'intermédiaire d'une boucle de courant passant reliant la phase neutre de l'alimentation électrique à la terre. Il existe cependant un type de réseau dans lequel aucune injection de courant n'est possible. Il s'agit de réseaux de type IT selon les normes CEI 60364 et CEI 60076-7. Ce type de réseaux présente une isolation entre le neutre et la terre, à la différence des réseaux domestiques classiques, appelés réseau de type TT selon ces normes, dans lesquels le neutre et la terre sont reliés. Les réseaux de type IT sont munis d'un transformateur d'isolement et d'un contrôleur permanent d'isolement. Les réseaux de type IT sont très utilisés dans les domaines où la fourniture d'électricité est vitale (hôpitaux, ...). La caractéristique principale de tels réseaux est de fournir de l'énergie électrique en aval d'un transformateur d'isolement, ce qui rend impossible l'injection de courant dans la terre du fait de l'isolement procuré par le transformateur. Le réseau est considéré également comme flottant du fait de l'absence de liaison à la terre. Cela présente l'avantage d'une absence de danger en cas de défaut d'isolement. Par contre, si deux défauts apparaissent, un court-circuit peut se produire. Pour cette raison, ce type de réseau est généralement équipé d'un détecteur d'isolement permettant d'agir rapidement et de corriger les défauts. Le détecteur d'isolement peut être un contrôleur permanent d'isolement.

Lors de la charge d'une batterie de véhicule électrique ou hybride muni d'un dispositif de mesure de la qualité de la liaison à la terre par le biais d'un tel réseau d'alimentation, utilisant une injection de courant dans la prise de terre tel qu'expliqué ci-dessus, la résistance mesurée est très importante, nettement supérieure à la résistance électrique d'un corps humain. Le dispositif de charge détecte alors un défaut d'isolation, ce qui s'avère être une erreur d'interprétation. Toutefois, les sécurités de fonctionnement rendent alors impossible la charge de la batterie du véhicule. Toutefois, cette détection est erronée et la charge de la batterie du véhicule aurait pu être réalisée en toute sécurité.

De l'état de la technique, on connaît les documents suivants.

Le document EP-642027 présente une méthode faisant varier la tension entre la phase neutre et la terre pour vérifier les défauts d'isolement.

Le document EP-959361 présente une méthode d'analyse de réseau IT en mesurant la composante continue de la tension entre une phase et la terre.

Le document EP-2505415 préconise de mesurer la résistance d'isolation du système de charge d'une batterie d'un véhicule électrique dont le réseau de bord est assimilé à un réseau IT, avant d'autoriser la charge du véhicule sur un réseau d'alimentation présentant une liaison à la terre. Lors de la charge sur un tel réseau, seuls les courants différentiels sont surveillés en entrée du système de charge, et la résistance d'isolation n'est plus mesurée.

Il existe donc un besoin de détection du type de réseau d'alimentation électrique et d'une modification des règles de sécurité en fonction du type de réseau détecté.

Un objet de l'invention est un procédé de détermination de la présence d'un réseau d'alimentation électrique comprenant un contrôleur permanent d'isolement et un transformateur d'isolement connecté en amont d'un chargeur de batterie automobile, ledit chargeur étant muni d'un dispositif d'estimation de la qualité de la terre par mesure de la fréquence du réseau et de la tension neutre-terre. Le chargeur de batterie comprend en outre des mécanismes de sécurité interdisant la charge de la batterie en fonction de la comparaison de la mesure de la tension neutre-terre avec une valeur de seuil. Le procédé comprend les étapes suivantes :

on réalise un filtrage en peigne de la tension neutre-terre mesurée par le chargeur de batterie en fonction d'une mesure de la fréquence du réseau, puis

on réalise un filtrage passe-haut, puis

on détermine la valeur absolue du signal filtré, puis

on applique un filtre à dynamique variable à la valeur absolue du signal filtré, et ensuite

on détermine si le signal obtenu à l'issue du filtrage à dynamique variable est supérieur à une valeur de seuil.

La fréquence de coupure du filtrage passe-haut peut être égale à la borne inférieure de la gamme de fréquences utilisées pour le signal injecté par le contrôleur permanent d'isolement.

Les étapes de filtrage peuvent être réalisées pendant au moins trois périodes du signal du contrôleur permanent d'isolement, à la fréquence minimale, avant de comparer le signal obtenu à la valeur de seuil.

Les étapes de filtrage peuvent être réalisées immédiatement avant le déclenchement de la charge.

Un autre objet de l'invention est un chargeur de batterie automobile connecté en aval d'un contrôleur permanent d'isolement et d'un transformateur d'isolement d'un réseau d'alimentation électrique. Ledit chargeur est muni d'un dispositif d'estimation de la qualité de la terre par mesure de la fréquence du réseau et de la tension neutre-terre, le chargeur de batterie comprenant en outre des mécanismes de sécurité interdisant la charge de la batterie en fonction de la comparaison de la mesure de la tension neutre-terre avec une valeur de seuil. Le chargeur de batterie comprend, connectés en série, un moyen de filtrage en peigne de la tension neutre-terre mesurée par le chargeur de batterie en fonction d'une mesure de la fréquence du réseau, un moyen de filtrage passe-haut, un moyen de détermination de la valeur absolue du signal filtré, un moyen de filtrage à dynamique variable de la valeur absolue du signal filtré, et un moyen de détermination apte à déterminer si le signal obtenu à l'issue du filtrage à dynamique variable est supérieur à une valeur de seuil.

La fréquence de coupure du filtrage passe-haut peut être égale à la borne inférieure de la gamme de fréquences utilisées pour le signal injecté par le contrôleur permanent d'isolement.

Les moyens de filtrage peuvent opérer pendant au moins trois périodes du signal du contrôleur permanent d'isolement ; à la fréquence minimale, avant de comparer le signal obtenu à la valeur de seuil.

Les moyens de filtrage peuvent être opérés immédiatement avant le déclenchement de la charge.

Un autre objet de l'invention est un véhicule équipé d'un chargeur de batterie tel que décrit ci-dessus.

Un avantage d'un tel procédé et d'un tel chargeur réside dans un gain en disponibilité de la charge, sans aucune modification matérielle. En effet, des mesures et informations déjà disponibles sont réutilisées. Le coût de mise en oeuvre est donc réduit. Les microcontrôleurs présents dans les chargeurs sont suffisamment puissants pour réaliser les calculs décrits.

D'autres buts, caractéristiques et avantages apparaîtront à la lecture de la description suivante donnée uniquement en tant qu'exemple non limitatif et faite en référence aux dessins annexés sur lesquels :

- la figure 1 illustre les principaux éléments d'un chargeur de batterie alimenté par un réseau électrique de type IT,
- la figure 2 illustre les principales étapes d'un procédé de détermination selon l'invention, et
- la figure 3 illustre les principaux éléments d'un chargeur de batterie automobile selon l'invention.

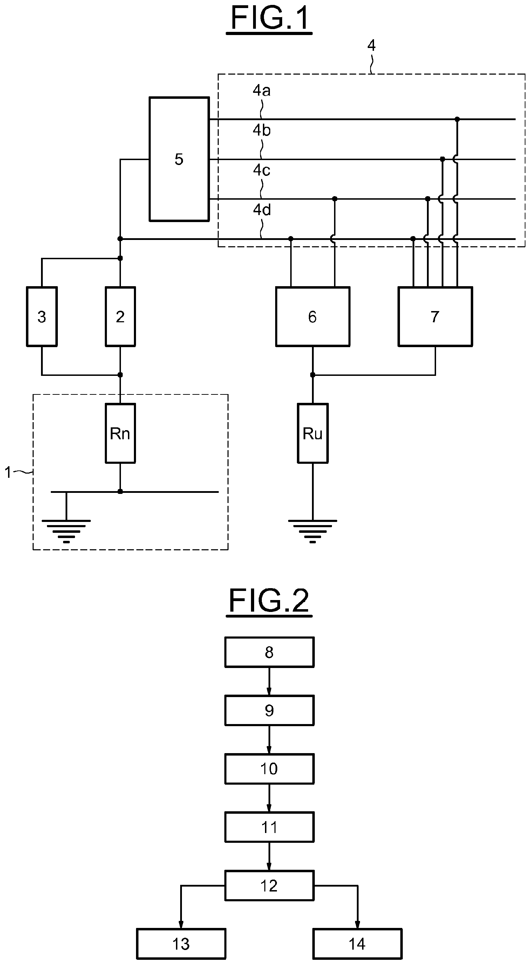

Sur la figure 1, on peut voir un réseau d'alimentation électrique 4 de type IT dont le neutre est isolé de la terre par un limiteur de surtension 2 et un contrôleur permanent d'isolement 3 connectés en parallèle. Ce réseau d'alimentation électrique 4 est connecté à la terre 1 en amont du limiteur de surtension de sorte qu'une première résistance Rn de prise de terre apparaît entre le limiteur de surtension 2 et la terre 1.

Un réseau d'alimentation triphasé 4 comprenant trois phases 4a,4b,4c et un neutre 4d est connecté en aval du limiteur de surtension à travers un transformateur d'isolement 5.

On peut voir également un récepteur monophasé 6 et un récepteur triphasé 7, connectés aux différentes phases du réseau d'alimentation triphasé 4 et munis tous deux d'une connexion à la terre de sorte qu'une deuxième résistance Ru de prise de terre apparaît entre ces récepteurs 6,7 et la terre. Les récepteurs 6,7 peuvent être des chargeurs de batterie du véhicule fonctionnant en triphasé ou en monophasé par exemple. Un nombre quelconque de récepteurs 6,7 peuvent être connectés au réseau d'alimentation triphasé 4.

Comme cela a été expliqué en introduction, le contrôleur permanent d'isolement 3 (acronyme CPI) est un détecteur de défaut d'isolement permettant de vérifier en continu l'isolement du réseau d'alimentation électrique 1 de type IT. Comme tout réseau d'alimentation électrique 1 de type IT est muni d'un CPI, il suffit d'en détecter la présence afin de déterminer que le réseau est de type IT.

Le fonctionnement d'un contrôleur permanent d'isolement 3 (CPI) consiste à tenter d'injecter un courant très basse-fréquence, par exemple inférieure à 5Hz, dans la terre. Pour injecter du courant dans la terre, le contrôleur permanent d'isolement 3 fait varier la tension entre la phase neutre et la terre. Si le réseau est bien isolé, cette variation de tension ne génère pas de courant et le réseau est considéré comme bien isolé. La variation de tension générée par le contrôleur permanent d'isolement peut prendre différentes formes, comme des oscillations ou des fronts de tension.

Le chargeur de batterie 6 est muni d'un dispositif de mesure de la qualité de la terre qui permet de mesurer la résistance à la terre du réseau d'alimentation électrique et d'empêcher la charge de la batterie si la mesure de résistance à la terre est inférieure à la résistance d'un être humain.

Le dispositif de mesure de la qualité de la terre comprend une première branche électrique reliant une borne de phase du réseau 4 et la borne de prise de terre du réseau 4. Sur cette branche est disposé un générateur de courant monté en série avec un ampèremètre et avec une diode configurée pour laisser passer le courant électrique du réseau uniquement dans le même sens que le courant injecté par le générateur de courant.

Le dispositif de mesure de la qualité de la terre comprend en outre une seconde branche électrique reliant une borne de branchement au neutre 4d du réseau 4 avec la borne de prise de terre. Sur cette seconde branche, sont disposées en série une première capacité et une résistance, aux bornes de laquelle est branché un premier voltmètre. Une unité de commande électronique est reliée au voltmètre et à l'ampèremètre afin de pouvoir collecter les valeurs mesurées par le voltmètre et par l'ampèremètre. L'unité de commande électronique est également reliée au générateur de courant de manière à pouvoir piloter une injection de courant dans la première branche du dispositif de mesure.

L'injection de courant par le générateur dans la seconde branche provoque un retour de courant par la prise de terre vers le neutre du réseau électrique, ainsi qu'une boucle de courant parallèle passant par la résistance.

Une résistance électrique peut être mesurée comme s'opposant au passage du courant entre la prise de terre et le neutre du réseau. Cette résistance électrique mesurée correspond à la résistance de terre que l'on souhaite mesurer à l'aide du dispositif de mesure correspondant.

Des procédures de mesure connues permettent à l'unité de commande électronique, à partir des valeurs délivrées par l'ampèremètre et le voltmètre, de déduire la valeur de la résistance de terre. Par exemple, on peut considérer en première approximation que la résistance de prise de terre a pour valeur $R_T$,

avec :

$$R_T = V/A,$$

où V est une tension mesurée par le premier voltmètre, et

A est l'intensité du courant mesurée dans le même temps par l'ampèremètre, notamment si la valeur $R_T$ ainsi déterminée est sensiblement inférieure à la valeur de la résistance disposée dans la seconde branche.

Comme cela a été expliqué en introduction, le dispositif de mesure de la qualité de la terre peut être mis en défaut par la combinaison de l'isolation du réseau IT et de la présence d'un CPI, la résistance de terre mesurée étant supérieure à celle d'un être humain. En effet, la résistance de terre est mesurée indirectement en mesurant la tension entre terre-neutre. Dans le cas d'une isolation parfaite, par exemple lorsque le chargeur est connecté à un réseau d'alimentation IT, aucune tension ne peut être mesurée. Toutefois, le CPI injectant une tension en aval du réseau d'alimentation électrique de type IT, la mesure de tension est non nulle. Les mécanismes de sécurité du chargeur de batterie 6 peuvent alors détecter, à tort, un défaut d'isolation en comparant la tension mesurée à une tension de seuil et interdire la charge de la batterie.

Il est toutefois possible d'éviter une telle situation en outrepassant les mécanismes de sécurité lorsque l'on détecte la présence d'un contrôleur permanent d'isolement en recherchant la présence d'une composante harmonique basse fréquence. Pour que la détection soit robuste, on recherche une composante harmonique révélant la présence d'un contrôleur permanent d'isolement dans une gamme de fréquence s'étendant de 0,1 Hz à 10Hz.

De plus, le chargeur de batterie étant muni d'un dispositif de mesure de la qualité de la terre, une mesure de la fréquence du réseau et une mesure de la tension neutre-terre sont disponibles. La mesure de qualité de terre est effectuée en mesurant la tension neutre-terre à la fréquence de 10kHz Ce signal peut être employé afin de détecter la présence d'un CPI.

Il est alors possible de réussir à identifier la présence d'une composante harmonique située entre 0,1Hz et 10Hz en utilisant un procédé de filtrage numérique du signal obtenu lors de la mesure de qualité de terre. Un exemple non limitatif d'un tel procédé va maintenant être décrit en relation avec la figure 2.

Sur la figure 2 est illustré un exemple de procédé de détection du type de réseau d'alimentation électrique qui comprend les étapes suivantes.

Au cours d'une première étape 8, on réalise un filtrage en peigne de la mesure de la tension neutre-terre réalisée par le chargeur de batterie 6 (connecté en triphasé ou en monophasé). Un filtrage en peigne permet d'éliminer un grand nombre d'harmoniques du réseau. Pour cela, la fréquence inférieure du filtre en peigne est calée sur la mesure de fréquence du réseau. Par exemple, on réalise un filtre en peigne numérique en faisant une moyenne de mesure à des instants bien choisis. Typiquement, pour éliminer un signal à 50Hz, on fait la moyenne de deux points du signal espacés de 10ms.

Au cours d'une deuxième étape 9, on réalise un filtrage passe-haut du signal obtenu. La fréquence de coupure du filtrage est de 0,1Hz de sorte que toutes les fréquences inférieures, notamment celles correspondant à une tension continue, soient supprimées. La fréquence de 0,1Hz correspond à la fréquence minimale d'un CPI 3 dans le commerce actuel.

Au cours d'une troisième étape 10, on détermine la valeur absolue du signal obtenu.

Enfin, au cours d'une quatrième étape 11, on applique un filtre à dynamique variable à la valeur absolue du signal filtré, montée rapide et descente lente. Un tel filtre permet d'obtenir l'effet d'un filtre écrêteur tout en ayant une information traitable de la richesse du signal dans la bande de fréquence ainsi sélectionnée.

On rappelle qu'un filtre à dynamique variable se comporte comme un filtre passe bas dans lequel la fréquence de coupure est modifiée dynamiquement en fonction de la comparaison du niveau d'entrée et de sortie. Si le signal d'entrée est supérieur au signal de sortie, la fréquence de coupure est déterminée de sorte que la bande passante soit importante, typiquement supérieure à 10kHz. La variation montante du signal pourra donc être rapide.

Si le signal d'entrée est inférieur au signal de sortie, la fréquence de coupure est déterminée de sorte que la bande passante soit faible, typiquement inférieure à 0.1Hz. La variation descendante du signal pourra donc être lente.

Au cours d'une cinquième étape 12, on compare ensuite le signal obtenu à une valeur de seuil, typiquement 1V. Si le signal obtenu est supérieur à la valeur de seuil, cela signifie qu'un contrôleur permanent d'isolement est en train d'injecter un signal quelconque dans la bande de fréquence s'étendant de 0,1 Hz à 10 Hz. Dans un tel cas, on peut alors autoriser le lancement de la charge, au cours d'une sixième étape 13. On rappelle que la fréquence de 0,1 Hz correspond à la fréquence minimale d'un CPI dans le commerce actuel, tandis que la fréquence de 10 Hz correspond à la fréquence maximale d'un CPI.

Si le signal obtenu est inférieur à la valeur de seuil, cela signifie qu'il n'y a pas de contrôleur permanent d'isolement en train d'injecter un signal quelconque dans la bande de fréquence s'étendant de 0,1 Hz à 10 Hz. Dans un tel cas, les mécanismes de sécurité relatifs à la qualité de la liaison à la terre sont maintenus au cours d'une septième étape 14.

On peut noter que ce traitement requiert un temps important. En effet, il peut être aisé de détecter un signal sinusoïdal variant à la fréquence de 0,1 Hz, toutefois, il sera beaucoup plus difficile de détecter un signal carré variant à la même fréquence. Si l'on considère trois changements de niveau d'un tel signal, on obtient une période de recherche d'un signal de 30 secondes. Il est donc nécessaire d'accorder un temps de traitement d'au moins 30 secondes à l'algorithme pour pouvoir identifier des fréquences pouvant descendre jusqu'à 0,1Hz. Cette détection doit donc être faite en dernier recours avant d'interdire le lancement de la charge de façon définitive.

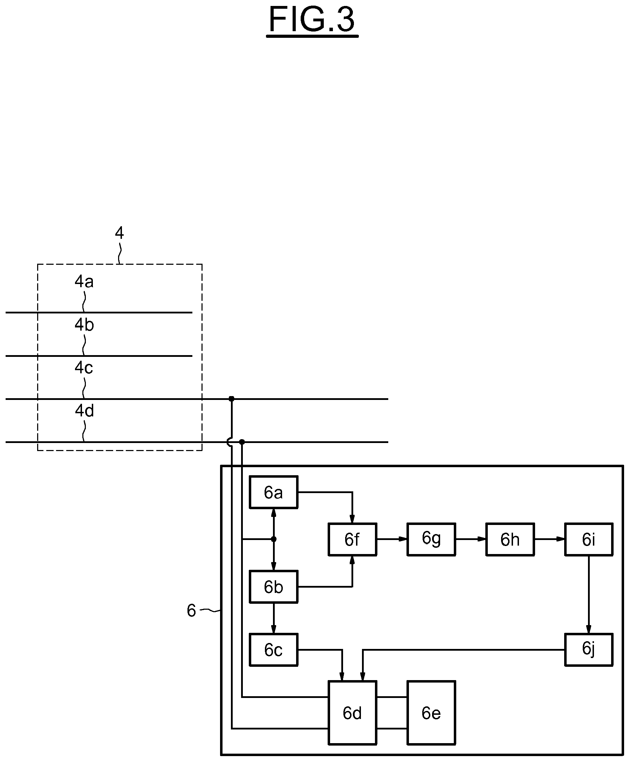

Sur la figure 3, on peut voir les principaux éléments d'un chargeur de batterie 6 automobile comprenant des moyens de détermination de la présence d'un réseau d'alimentation électrique 4 de type IT.

Le chargeur de batterie 6 comprend des moyens de mesure 6a de la fréquence du réseau, des moyens de mesure 6b de la tension neutre-terre et des moyens de sécurité 6c aptes à autoriser ou à empêcher la charge. Les moyens de sécurité 6c reçoivent notamment la mesure de tension neutre-terre et sont reliés en sortie à un relais 6d apte à interrompre ou à établir l'alimentation électrique des composants de puissance 6e du chargeur connectés par son intermédiaire au neutre 4d et à une phase 4c du réseau triphasé. Le chargeur peut également être triphasé, auquel cas les composants de puissance 6e sont connectés aux trois phases 4a,4b,4c. Bien que non représenté, on comprendra que les composants de puissance 6e sont par ailleurs connectés à la batterie à charger.

Le chargeur 6 comprend par ailleurs un moyen de filtrage en peigne 6f relié en entrée aux moyens de mesure 6a de la fréquence du réseau et aux moyens de mesure 6b de la tension neutre-terre, et, connectés en série en sortie du moyen de filtrage en peigne 6f, un moyen de filtrage passe-haut 6g, un moyen de détermination 6h de la valeur absolue du signal filtré, un moyen de filtrage à dynamique variable 6i, et un moyen de détermination 6j apte à déterminer si le signal obtenu à l'issue du filtrage à dynamique variable est supérieur à une valeur de seuil.

Le moyen de détermination 6j est connecté en sortie au relais 6d, de sorte que le signal du moyen de détermination 6j soit prioritaire sur le signal issu des moyens de sécurité 6c.

Le chargeur de batterie 6 est ainsi apte à réaliser un filtrage de la mesure neutre-terre afin de détecter la présence d'un contrôleur permanent d'isolement. Dans un tel cas, la commande d'interdiction de la charge des mécanismes de sécurité est outrepassée afin de tenir compte du réseau de type IT détecté.

**Revendications**

1. Procédé de détermination de la présence d'un réseau d'alimentation électrique (4) comprenant un contrôleur permanent d'isolement (3) et un transformateur d'isolement (5) connecté en amont d'un chargeur (6) de batterie automobile, ledit chargeur étant muni d'un dispositif d'estimation de la qualité de la terre par mesure de la fréquence du réseau et de la tension neutre-terre, le chargeur de batterie (6) comprenant en outre des mécanismes de sécurité interdisant la charge de la batterie en fonction de la comparaison de la mesure de la tension neutre-terre avec une valeur de seuil, **caractérisé par le fait qu'**il comprend les étapes suivantes :

   on réalise un filtrage en peigne de la tension neutre-terre mesurée par le chargeur de batterie (6) en fonction d'une mesure de la fréquence du réseau, puis
   on réalise un filtrage passe-haut, puis

on détermine la valeur absolue du signal filtré, puis

on applique un filtre à dynamique variable à la valeur absolue du signal filtré, et ensuite

on détermine si le signal obtenu à l'issue du filtrage à dynamique variable est supérieur à une valeur de seuil.

2. Procédé selon la revendication précédente, dans lequel la fréquence de coupure du filtrage passe-haut est égale à la borne inférieure de la gamme de fréquences utilisées pour le signal injecté par le contrôleur permanent d'isolement.

3. Procédé selon la revendication précédente, dans lequel les étapes de filtrage sont réalisées pendant au moins trois périodes du signal du contrôleur permanent d'isolement (3), à ladite fréquence de coupure, avant de comparer le signal obtenu à la valeur de seuil.

4. Procédé selon l'une des revendications précédentes, dans lequel les étapes de filtrage sont réalisées immédiatement avant le déclenchement de la charge.

5. Chargeur de batterie automobile connecté en aval d'un contrôleur permanent d'isolement et d'un transformateur d'isolement (5) d'un réseau d'alimentation électrique (4)

ledit chargeur étant muni d'un dispositif d'estimation de la qualité de la terre par mesure de la fréquence du réseau et de la tension neutre-terre, le chargeur de batterie (6) comprenant en outre des mécanismes de sécurité (6c) interdisant la charge de la batterie en fonction de la comparaison de la mesure de la tension neutre-terre avec une valeur de seuil, **caractérisé par le fait qu'**il comprend, connectés en série, un moyen de filtrage en peigne (6f) de la tension neutre-terre mesurée par le chargeur de batterie (6) en fonction d'une mesure de la fréquence du réseau, un moyen de filtrage passe-haut (6g), un moyen de détermination (6h) de la valeur absolue du signal filtré, un moyen de filtrage à dynamique variable (6i) de la valeur absolue du signal filtré, et un moyen de détermination (6j) apte à déterminer si le signal obtenu à l'issue du filtrage à dynamique variable est supérieur à une valeur de seuil.

6. Chargeur selon la revendication 5, dans lequel la fréquence de coupure du filtrage passe-haut est égale à la borne inférieure de la gamme de fréquences utilisées pour le signal injecté par le contrôleur permanent d'isolement.

7. Chargeur selon la revendication 6, dans lequel les moyens de filtrage opèrent pendant au moins trois périodes du signal du contrôleur permanent d'isolement (3), à ladite fréquence de coupure, avant de comparer le signal obtenu à la valeur de seuil.

8. Chargeur selon l'une des revendications 5 à 7, dans lequel les moyens de filtrage sont opérés immédiatement avant le déclenchement de la charge.

9. Véhicule équipé d'un chargeur selon l'une des revendications précédentes.

**Patentansprüche**

1. Verfahren zum Bestimmen des Vorhandenseins eines elektrischen Versorgungsnetzes (4), das eine permanente Trennsteuereinheit (3) und einen Trenntransformator (5), der einer Kraftfahrzeugbatterie-Ladevorrichtung (6) vorgeschaltet ist, umfasst, wobei die Ladevorrichtung mit einer Vorrichtung zum Schätzen der Qualität von Masse durch Messen der Frequenz des Netzes und der Neutral-Masse-Spannung versehen ist, wobei die Batterieladevorrichtung (6) außerdem Sicherheitsmechanismen umfasst, die in Abhängigkeit von dem Vergleich der Messung der Neutral-Masse-Spannung mit einem Schwellenwert das Laden der Batterie verhindern, **gekennzeichnet durch** die folgenden Schritte:

Ausführen einer Kammfilterung der Neutral-Masse-Spannung, die **durch** die Batterieladevorrichtung (6) gemessen wird, als Funktion einer Messung der Frequenz des Netzes, dann Ausführen einer Hochpassfilterung, dann Bestimmen des Absolutwerts des gefilterten Signals, dann Anwenden eines Filters mit variabler Dynamik auf den Absolutwert des gefilterten Signals und schließlich Bestimmen, ob das von der Filterung mit variabler Dynamik erhaltene Signal größer als ein Schwellenwert ist.

2. Verfahren nach dem vorhergehenden Anspruch, wobei die Kappungsfrequenz der Hochpassfilterung gleich der unteren Grenze des Bereichs von Frequenzen ist, die für das durch die permanente Trennsteuereinheit eingespeiste Signal verwendet werden.

3. Verfahren nach dem vorhergehenden Anspruch, wobei die Filterungsschritte während wenigstens dreier Perioden des Signals der permanenten Trennsteuereinheit (3) mit der Kappungsfrequenz ausgeführt werden, bevor das erhaltene Signal mit den Schwellenwert verglichen wird.

4. Verfahren nach einem der vorhergehenden Ansprüche, wobei die Filterungsschritte direkt vor dem Beginnen des Ladevorgangs ausgeführt werden.

5. Kraftfahrzeugbatterie-Ladevorrichtung, die einer permanenten Trennsteuereinheit und einem Trenntransformator (5) eines elektrischen Versorgungsnetzes (4) nachgeschaltet ist, wobei die Ladevorrichtung mit einer Vorrichtung zum Schätzen der Qualität von Masse durch Messen der Frequenz des Netzes und der Neutral-Masse-Spannung versehen ist, wobei die Batterieladevorrichtung (6) außerdem Sicherheitsmechanismen (6c) umfasst, die in Abhängigkeit von dem Vergleich der Messung der Neutral-Masse-Spannung mit einem Schwellenwert das Laden der Batterie verhindert, **dadurch gekennzeichnet, dass** sie in einer Reihenschaltung Folgendes umfasst:

   ein Mittel (6f) zum Kammfiltern der durch die Batterieladevorrichtung (6) gemessenen Neutral-Masse-Spannung als Funktion einer Messung der Netzfrequenz,
   ein Hochpassfilterungsmittel (6g),
   ein Mittel (6h) zum Bestimmen des Absolutwerts des gefilterten Signals,
   ein Mittel (6i) zum Filtern mit variabler Dynamik des Absolutwerts des gefilterten Signals und
   ein Bestimmungsmittel (6j), das bestimmen kann, ob das von der Filterung mit variabler Dynamik erhaltene Signal größer als ein Schwellenwert ist.

6. Ladevorrichtung nach Anspruch 5, wobei die Kappungsfrequenz der Hochpassfilterung gleich der unteren Grenze des Bereichs von Frequenzen ist, die für das durch die permanente Trennsteuereinheit eingespeiste Signal verwendet werden.

7. Ladevorrichtung nach Anspruch 6, wobei die Filterungsmittel während wenigstens dreier Perioden des Signals der permanenten Trennsteuereinheit (3) mit der Kappungsfrequenz arbeiten, bevor das erhaltene Signal mit dem Schwellenwert verglichen wird.

8. Ladevorrichtung nach einem der Ansprüche 5 bis 7, wobei die Filterungsmittel direkt vor dem Beginnen des Ladens betrieben werden.

9. Fahrzeug, das mit einer Ladevorrichtung nach einem der vorhergehenden Ansprüche ausgerüstet ist.

**Claims**

1. Method for determining the presence of an electric power supply network (4) comprising a permanent insulation tester (3) and an isolating transformer (5) connected upstream of a motor vehicle battery charger (6), said charger being provided with a device for estimating the quality of the earth by measuring the frequency of the network and the neutral-earth voltage, the battery charger (6) further comprising safety mechanisms preventing the charging of the battery based on the comparison of the measurement of the neutral-earth voltage with a threshold value, **characterized in that** it comprises the following steps:

   a comb filtering is applied to the neutral-earth voltage measured by the battery charger (6) as a function of a measurement of the frequency of the network, then
   a high-pass filtering is performed, then the absolute value of the filtered signal is determined, then
   a filter with variable dynamic range is applied to the absolute value of the filtered signal, and then a determination is made as to whether the signal obtained from the filtering with variable dynamic range is above a threshold value.

2. Method according to the preceding claim, in which the cut off frequency of the high-pass filtering is equal to the lower limit of the range of frequencies used for the signal injected by the permanent insulation tester.

3. Method according to the preceding claim, in which the filtering steps are carried out during at least three periods of the signal from the permanent insulation tester (3), at said cut off frequency, before the signal obtained is compared to the threshold value.

4. Method according to one of the preceding claims, in which the filtering steps are carried out immediately before the triggering of the charging.

5. Motor vehicle battery charger connected downstream of a permanent insulation tester and of an isolating transformer (5) of an electrical power supply network (4) said charger being provided with a device for estimating the quality of the earth by measuring the frequency of the network and the neutral-earth voltage, the battery charger (6) further comprising safety mechanisms (6c) preventing the charging of the battery based on the comparison of the measurement of the neutral-earth voltage with a threshold value, **characterized in that** it comprises, connected in series, a means (6f) for comb filtering the neutral-earth voltage measured by the battery charger (6) as a function of a measurement of the frequency of the network,

a high-pass filtering means (6g),
a means (6h) for determining the absolute value of the filtered signal,
a filtering means with variable dynamic range (6i) for the absolute value of the filtered signal, and
a determination means (6j) capable of determining whether the signal obtained from the filtering with variable dynamic range is above a threshold value.

6. Charger according to Claim 5, in which the cut off frequency of the high-pass filtering is equal to the lower limit of the range of frequencies used for the signal injected by the permanent insulation tester.

7. Charger according to Claim 6, in which the filtering means operate during at least three periods of the signal from the permanent insulation tester (3), at said cut off frequency, before comparing the signal obtained to the threshold value.

8. Charger according to one Claims 5 to 7, in which the filtering means are applied immediately before the triggering of the charging.

9. Vehicle equipped with a charger according to one of the preceding claims.

# FIG.1

# FIG.2

# FIG.3

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 642027 A
- EP 959361 A
- EP 2505415 A